# EUROPEAN PATENT APPLICATION

(11) **EP 0 552 697 A2**
(43) Date of publication of application: **28.07.1993**
(21) Application number: 93100657.1
(22) Date of filing: 18.01.1993
(51) Int. Cl.: H01L 29/73, H01L 21/331

(54) **An SOI lateral bipolar transistor with a polysilicon emitter**

(30) Priority: 24.01.1992 US 825137
(71) Applicant: INTERNATIONAL BUSINESS MACHINES CORPORATION, Armonk, N.Y. 10504 (US)
(72) Inventor: Davari, Bijan, Mahopac, New York 10541 (US); Ning, Tak Hung, Yorktown Heights, New York 10598 (US); Shahidi, Ghavam Ghavami, White Plains, New York 10606 (US)
(74) Representative: Schäfer, Wolfgang, Dipl.-Ing.

(57) **Abstract**

The present invention solves the problems present in the prior art by forming a lateral emitter base junction of a bipolar transistor in which an N+ polysilicon layer forms the emitter. This is accomplished by attaching the polysilicon emitter to a vertical surface of the single crystal silicon. Single crystal silicon (102) is grown on a dielectric (104) and covered with another dielectric layer and an extrinsic base polysilicon layer (106). Polysilicon sidewall spacers (112) are formed as an edge strap connection between the extrinsic base and the single crystal silicon. The edge strap is isolated from the remainder of the device by a second sidewall spacer (114). An intrinsic base region (150) is formed in the single crystal silicon using the sidewall spacer as one defining edge of the intrinsic base region. The intrinsic base region (150) diffuses under the sidewall spacers. The single crystal silicon is etched to the underlying dielectric using the second sidewall spacer as one defining edge. This etch removes all the intrinsic base region except that under the sidewall spacers and leaves a vertical surface of the single crystal silicon exposed. This exposed vertical surface is the intrinsic base region. Conformal N type polysilicon (125) is then deposited to form an emitter contact on the vertical surface of the single crystal silicon intrinsic base region.

## Description

This invention relates generally to the field of semiconductor devices. In particular, this invention relates to silicon on insulator (SOI) semiconductor devices. Specifically, this invention relates to a high performance bipolar semiconductor device formed on an insulator structure.

Manufacturers of semiconductor devices are continually searching for new methods to give the devices that are built a higher performace. The search for new methods of fabricating devices is especially important in bipolar devices because bipolar devices are typically used just to take advantage of thier inherent performance advantage over Field Effect Transistor (FET) devices. In addition to seeking the highest performance devices, manufacturers must also ensure that the high performance devices are compatible with the ability to make smaller devices through improved photolithographic techniques, and increasingly, the bipolar process must be compatible with FET processing. These requirements are imposed because the semiconductor devices must provide an increased number of functions as well as performing individual functions faster.

In the manufacturing of semiconductor devices, the goals of making a device smaller and faster are not necessarily complimentary. This is because the parasitic effects which slow down devices do not just depend on the small size of a device, but also depend on the ratio of various geometries of a device. For example, the parasitic capacitance on the emitter of a bipolar transistor does not just depend on the emitter area of the active device. It also depends on the linear perimeter of the emitter area. This results in the fact that even though the device may be smaller, the parasitic elements may still operate in a manner which makes the performance of the device slower. In addition, the processes associated with fabricating high performance bipolar transistors and FET devices on the same seimconductor chip are not necessarily compatible. This typically results in either the FET or the bipolar devices (or both) not having optimum performance.

The prior art has attempted to enhance the performance of bipolar devices while maintaining minimum device size and FET process compatibility by fabricating the devices in a silicon on insulator structure. In this structure, a thin layer of silicon is grown over an insulator layer such as silicon dioxide, silicon nitride, quartz, or other material. The silicon is patterned into individual pedestals of silicon through conventional photolithographic and etching means. The space between the pedestals is then filled with more of the insulator material. Finally, the bipolar device is built into the silicon pedestal. This structure eliminated the large spacing between devices which slowed the performance of the devices by increasing the parasitic elements the individual devices had to overcome. Additionally, because the large junction spacings were eliminated, the size of designs using the devices were reduced. More importantly, the elimination of the junction isolation (as opposed to the insulator isolation) and the single crystal silicon substrate decreased the bipolar transistor collector to isolation, base to isolation, and collector to substrate parasitic capacitance. These capacitances directly affected the device performance and their elimination improved performance substantially.

A further enhancement to the performance of bipolar devices was to fabricate the p-n emitter base junction of the device in a lateral rather than vertical fashion. The problem with this type of device was that the formation of the emitter base junction depended on the relative placement of two photolithographic masks. This type of device would have a very large basewidth, and would have poor performance. A solution to the problem of a large base width in a lateral bipolar device in a SOI structure required a fabrication sequence which did not rely on the relative placement of two photolithographic masks to define the base width of the bipolar device. The prior art solved this problem by using a combination of sidewall spacer technology and ion implantation techniques. Specifically, a silicon layer was grown on the insulator and was covered by another insulator layer and a first polysilicon layer. The first polysilicon layer was then heavily doped to a first type (i.e. P type for an NPN or N type for a PNP). The first polysilicon layer and the overlying insulator were etched to expose the underlying silicon layer and to form the base contact layer. A polysilicon sidewall spacer was then placed on the sidewalls of the remaining first polysilicon layer. An ion implant of the first type of dopant was now done to form the base region. A second sidewall spacer of silicon nitride followed this implant to cover the first polysilicon sidewall spacer. A heavy emitter doping of a second type (i.e. N type for an NPN or P type for a PNP) was carried out on the still exposed underlying silicon layer. The structure is annealed to let the dopants from the first polysilicon layer and the underlying silicon outdiffuse into the second polysilicon layer. The second polysilicon layer becomes conductive after the anneal and connects the base layer to the base width and has a pn junction between the emitter diffusion and the basewidth of the device. The resulting device has a basewidth which is dependant on the differences in doping profiles in the lateral direction, and therefore, the basewidth can be made very small (and hence the resulting device has high performance) with respect to a basewidth formed by overlapping photolithographic mask layers. The problem with this device is that even though the basewidth is reduced, the device performance is still less than optimal because the emitter diffusion is located in the underlying silicon layer. When the emitter is located in the underlying silicon layer, the metal silicide contact to the emitter is spaced very close to the emitter-base junction. This spacing is typically less than a sidewall spacer thickness and less than the minority carrier diffusion length of the emitter region. This close spacing between the metal silicide contact to the emitter and the emitter-base junction degrades the gain and performance of the device.

The invention is intended to remedy these drawbacks.

The present invention as claimed solves the problems present in the prior art by forming a lateral emitter base junction of a bipolar transistor in which an N+ polysilicon layer forms the emitter. This is accomplished by attaching the polysilicon emitter to a vertical surface of the single crystal silicon. Single crystal silicon is grown on a dielectric and covered with another dielectric layer and an extrinsic base polysilicon layer. Polysilicon sidewall spacers are formed as an edge strap connection between the extrinsic base and the single crystal silicon. The edge strap is isolated from the remainder of the device by a second sidewall spacer. An intrinsic base region is formed in the single crystal silicon using the sidewall spacer as one defining edge of the intrinsic base region. The intrinsic base region diffuses under the sidewall spacers. The single crystal silicon is etched to the underlying dielectric using the second sidewall spacer as one defining edge. This etch removes all the intrinsic base region except that under the sidewall spacers and leaves a vertical surface of the single crystal silicon exposed. This exposed vertical surface is the intrinsic base region. Conformal N type polysilicon is then deposited to form an emitter contact on the vertical surface of the single crystal silicon intrinsic base region. The resulting vertical emitter base junction has fewer parasitic capacitances because it is isolated by dielectric films. The device also has higher gain, and therefore performance, because of the polysilicon emitter. Finally, the device does not depend on the relative placement of photolithographic masks for the formation of the basewidth, and as a result, basewidths much smaller than the minimum photolithographic dimension can be achieved which increases device performance.

It is an advantage of the present invention to manufacture a high performance bipolar device having reduced parasitic elements, and a high performance bipolar device having high device gain.

It is a further advantage of the present invention to manufacture a high performance bipolar device compatible with submicron photolithography and which is compatible with FET device processing.

For a better understanding of the present invention, together with further objects and advantages, preferred embodiments of the invention are described in the following with reference to the accompanying drawings, in which:
- Figure 1: illustrates a prior art bipolar device structure.
- Figure 2: illustrates a top view of the layout of the present invention.
- Figure 3: illustrates a cross section of the bipolar device of the present invention along cut AA of figure 2.
- Figure 4: illustrates a cross section of the present invention at an intermediate step in the fabrication process.
- Figure 5: illustrates a cross section of the present invention after the extrinsic base region is defined.
- Figure 6: illustrates a cross section of the present invention after the emitter side single crystal silicon is exposed.
- Figure 7: illustrates a cross section of the present invention after the sidewall spacers are formed and the intrinsic base region is ion implanted.
- Figure 8: illustrates a cross section of the present invention after the HYPOX process is performed.
- Figure 9: illustrates a cross section of the present invention after the emitter side single crystal silicon is etched.
- Figure 10: illustrates a cross section of the present invention after the N+ polysilicon layer is deposited.
- Figure 11: illustrates a cross section of the present invention after extrinsic base contact is defined.
- Figure 12: illustrates a cross section of the present invention after the silicide formation on the N and P type polysilicon contacts.
- Figure 13: illustrates a cross section of the present invention after a passivation layer has been deposited and metal contacts formed.

The present invention is a silicon on insulator (SOI) lateral bipolar device which has high performance due to the fact that the emitter is formed from a polysilicon layer rather than in the single crystal silicon. Additionally, the basewidth of the bipolar device does not depend on the relative alignment of two photolithographic mask levels so it can be manufactured with a very small lateral dimension and therefore, improve performance. The formation of the basewidth independant of overlapping mask layers also makes the device compatible with decreasing photolithography dimensions because the gain of the device is not modulated by the photolithography. Further, the parasitic capacitance elements associated with typical base-collector, base-isolation, and collector-substrate junctions do not exist in the present invention because of the silicon on insulator structure of the present device. The present invention is also not subject to the parasitic effects of a silicide layer abutting the emitter-junction. Finally, The structure of the present invention is compatible with FET device processing because high temperature anneals are not required which degrade FET device performance. The following description of the invention describes the device in terms of specific N and P type materials and in terms of specific well known photolithography and etching steps. Substitution for the N or P type materials with the opposite type of material creates an equivalent structure in all pertinent respects to the structure which is specifically described. Additionally, well known photolithography and etching steps are employed in the fabrication of this invention. They are common in the manufacture of seimconductor devices and therefore will not be described in detail although relevant aspects will be particularly pointed out.

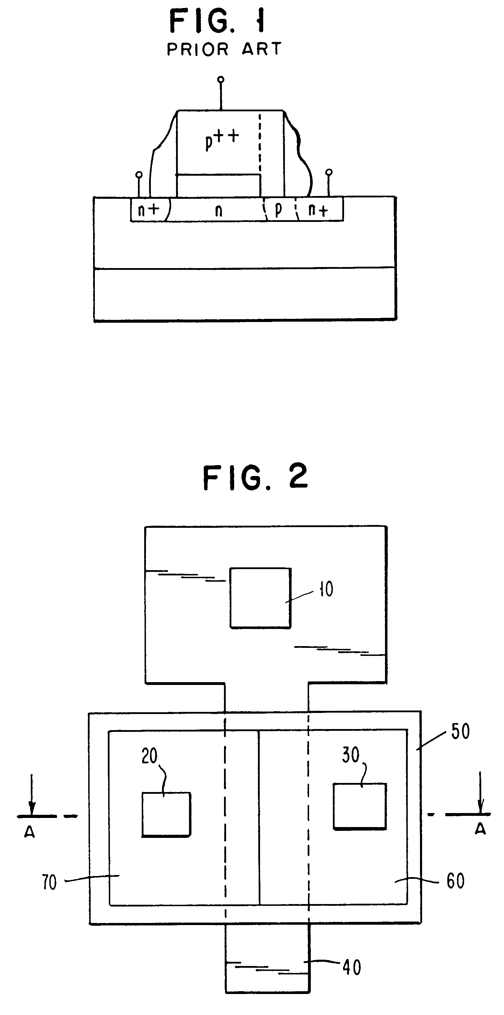

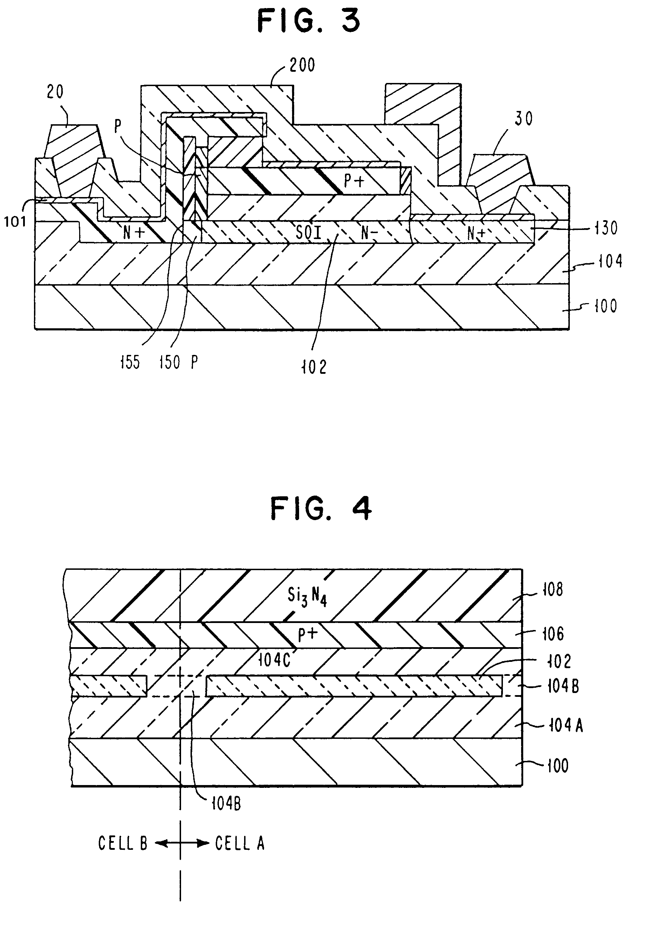

Figure 2 illustrates a top view of the layout of the present invention. The bipolar device depicted in figure 2 has an emitter contact 20, an extrinsic base contact 10, and a collector contact 30. The collector 60 is formed in the single crystal silicon layer of the device structure. The extrinsic base layer 40 is formed from a P+ doped layer of polysilicon. The emitter 70 is formed from an N+ polysilicon layer. The emitter 70 and collector 60 areas each have an overlapping edge onto the extrinsic base layer 40. The isolation region 50 surrounds the remaining 3 edges of the collector 60 and emitter 70 which are not overlapping the extrinsic base layer 40. Figure 3 illustrates a cross section along cut AA of figure 2 of the final structure of the bipolar device of the present invention. The emitter contact 20 contacts a titanium silicide layer 101 which is formed on an N+ polysilicon layer. The N+ polysilicon layer and the p-type region 150 form the emitter base junction of the NPN transistor. The base-collector junction is formed from region 150 and 102. The collector contact 30 contacts a titanium silicide layer which is formed on a single crystal N+ type region 130. Region 130 contacts region 102. The base contact 10 (not shown in figure 3) contacts the titanium silicide layer which is formed on the P+ type polysilicon layer. The P+ polysilicon layer contacts the single crystal p-type base through a vertical p-type layer. The function of the individual elements of the device can be more completely understood from the following description of process of fabricating the device.

Figure 4 illustrates a cross section of the present invention at an intermediate step in the fabrication process. Specifically, figure 4 illustrates a substrate 100 covered by a silicon dioxide layer 104. Layer 104 has three regions: 104A, 104B, and 104C, which encapsulate a silicon on insulator layer (SOI) 102. The 104A region lies between the SOI layer 102 and the substrate 100. Region 104B surrounds layer 102 on all sides. Figure 4 illustrates that the region 104B laterally separates the SOI layer 102 in cell A from the SOI layer 102 in cell B. Region 104C separates the SOI layer 102 from a P+ polysilicon layer 106. The P+ polysilicon layer 106 is, in turn, covered by a silicon nitride layer 108. SOI films are fabricated using a number of well known methods such as high dose implantation of oxygen into silicon and anneal (SIMOX), by depositing polysilicon on oxide and recrystalizing through seed areas, or by lateral epitaxial growth of silicon through seed holes and subsequent polishing back of the structure. The isolation regions correspond to regions 104B. A layer of silicon dioxide 104C then deposited on the SOI layer and on the isolation regions. Finally, layers of P+ polysilicon, and silicon nitride are deposited.

The substrate 100 is very thick (on the order of 600 microns) compared to the remaining layers in this structure. The silicon dioxide in region 104A is approximately 200 to 800 nanometers thick. The single crystal silicon is approximately 100 to 200 nanometers thick and is doped N type to approximately 10¹⁷ atoms per cubic centimeter. The n-type dopant is typically phosphorous or arsenic. The thickness and doping level of the silicon layer can be varied to further optimize device performance. The dielectric which is between the SOI 102 and the polysilicon layer 106 is approximately 100 to 200 nm thick. The dielectric need not be silicon dioxide but could be any dielectric such as silicon nitride or a combination of silicon dioxide and silicon nitride. The polysilicon layer 106 is approximately 100 to 400 nm thick and is heavily doped P type. The p-type dopant is typically boron. Typically this doping exceeds 10²¹/cm³. Finally, the silicon nitride layer 108 has a thickness of approximately 100 - 300nm. Again, this dielectric could be other than silicon nitride such as quartz or a combination of silicon dioxide and silicon nitride.

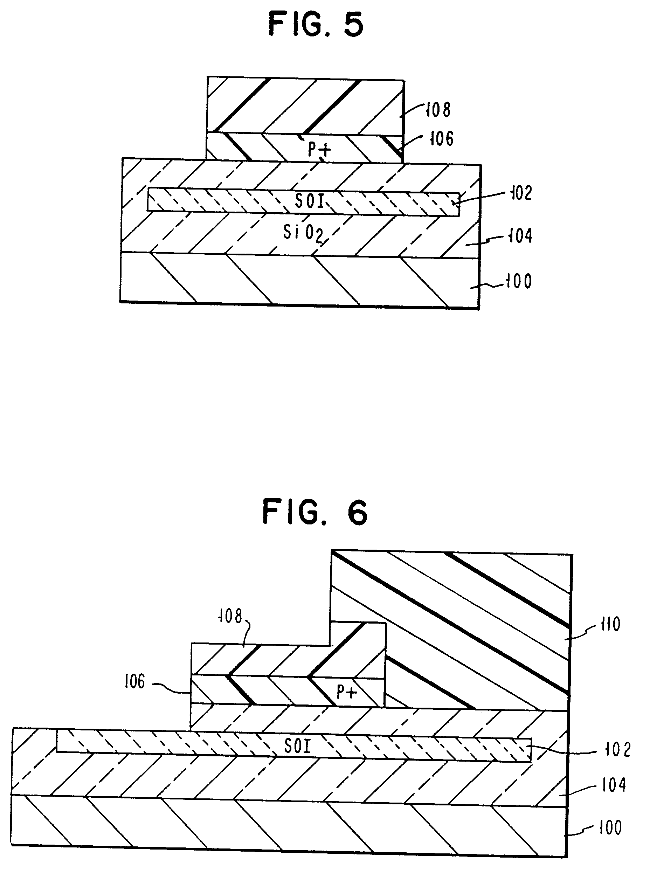

Figure 5 illustrates a cross section of the invention along cut AA after the patterning and etching of the extrinsic base layer. Photoresist is applied to the entire surface of figure 4. The resist is patterned and developed. The entire surface of the wafer is then subjected to an etching process which removes the silicon nitride dielectric and the polysilicon layers but does not remove the silicon dioxide layer covering the single crystal silicon. This is accomplished through a conventional reactive ion etch (RIE) which has an etch rate and etch time calibrated to stop on the silicon dioxide surface. Once the extrinsic base layer 106 has been formed, the oxide covering the emitter window must be removed. Figure 6 illustrates this process. Photoresist is again blanket deposited over the device. The photoresist is developed such that photoresist 110 protects the collector area, but exposes the emitter area and a portion of the base region (covered by silicon nitride) to the etch process. The etch process used for this step is an RIE process with a calibrated time and etch rate. The RIE process removes the thickness of silicon dioxide covering the single crystal silicon and removes that same thickness over the isolation which is not protected by resist 110. The RIE process also removes a portion of the thickness of the silicon nitride which covers the extrinsic base layer 106. The portion of the silicon nitride layer 108 which is protected by resist 110 is not etched.

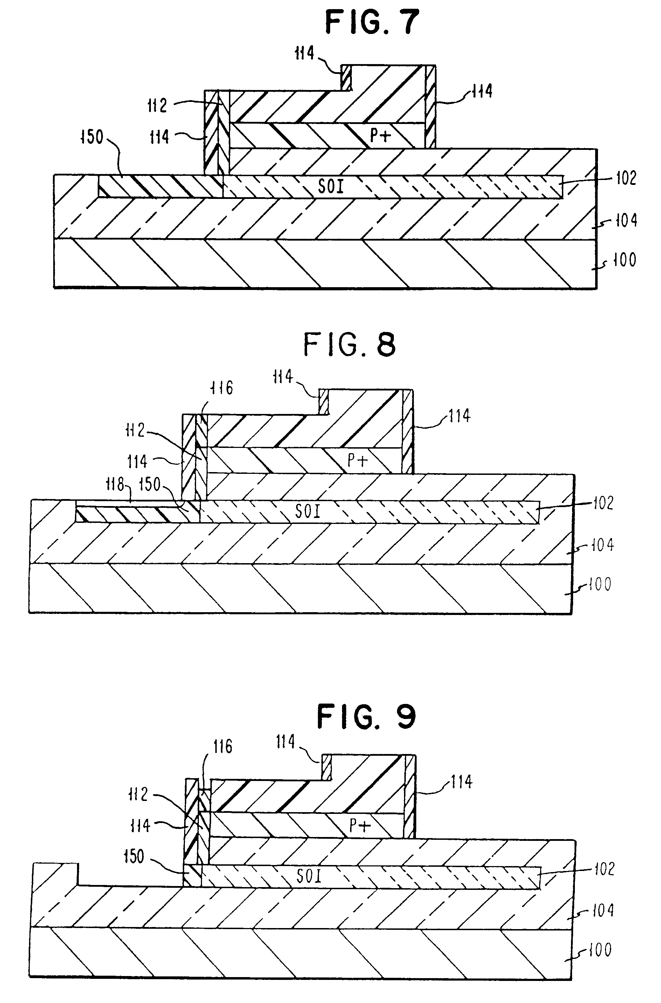

Figure 7 illustrates the formation of sidewall spacers which are used to form a contact between the extrinsic base layer 106 and a yet to be formed intrinsic base of the bipolar device. Once the emitter side silicon has been exposed as shown in figure 6, a conformal layer of heavily doped (p-type, approximately 10²⁰/cm³) polysilicon is deposited over the structure. This conformal layer has a thickness of approximately 50 to 100 nm. The conformal layer is then subjected to a blanket RIE process. The RIE process is calibrated to etch off the full thickness of the polysilicon deposited. However, the polysilicon which extends vertically from the surface of the structure is not etched. This is because the RIE process etches vertically but does not have a substantial horizantal etch rate. Therefore, layers which adhere to vertical sidewalls are not etched even though their horizantal parts are etched away. A photoresist layer is then blanket deposited and subsequently developed to cover the emitter area and the adjacent polysilicon sidewall spacer. However, the developed photoresist does not cover the polysilicon sidewall spacer which is not adjacent the emitter area. An isotropic RIE step is done to remove the polysilicon spacer everywhere except under the developed photoresist which leaves the polysilicon sidewall spacers 112 in figure 7.

Once the polysilicon sidewall spacers 112 have been formed, the same process of a blanket deposition of material followed by a blanket anisotropic RIE step is used to form silicon nitride spacers 114 over the vertical surfaces. The silicon nitride spacer layer can also be made of other dielectric materials such as combinations of silicon nitride and silicon dioxide. Several features of the dual spacer layers are important. First, the polysilicon layer 112 contacts the extrinsic base polysilicon layer 106. Second, the polysilicon layer 112 also contacts the single crystal layer 102. Therefore, the sidewall spacer 112 can form an electrical connection between the extrinsic base 106 and the single crystal silicon layer 102. In addition, the silicon nitride spacer layer 114 isolates the polysilicon spacer 112 from any emitter side electrical contacts. The thickness of the silicon nitride spacer layer is approximately 50 to 200 nm. This is important because the spacer layer 114 must be thick enough to isolate the polysilicon spacer 112 from any emitter connection and yet thin enough to form a good connection to the intrinsic base described below.

Once the sidewall spacers 112 and 114 are formed the intrinsic base 150 is formed. This is done by a blanket implant of P type dopant into the exposed emitter areas. The implant doses and energy conditions are adjusted to form a uniform lateral base profile. Typical implant conditions are implant of Boron at an energy of 5 keV with a dose of 5x10¹³/cm² and Boron implanted at 30 kev with a dose of 1x10¹⁴/cm². The implant mainly dopes the exposed silicion. However, the implant also dopes a portion of the silicon underlying the sidewall spacers 112 and 114. This is because of the lateral straggle of the ion implanted dopant. As a result, some dopant is implanted under the edge of the spacers. Moreover, the dopant outdiffuses laterally. The outdiffusion of the dopant under the spacer layers 112 and 114 may be enhanced by a short thermal anneal performed after the implant at high temperature (for example 1000 degrees celcius for 5 seconds). The thickness of spacer layer 114 is important because this is the thickness which the outdiffusion must overcome to make a good contact with the polysilicon layer. There is no need to mask the dopant implant because only the single crystal silicon is exposed to the implant and this is where the implant is designed to go. Most of the remainder of the surface of the structure is nitride or oxide which would cause no problem when exposed to the implant. Even though the horizantal surfaces of the polysilicon spacer layers 112 are implanted with P type dopant, there is no effect from this implant because the spacer layer 112 is already heavily doped P type. An alternate implantation process is to do the implantation after the formation of the polysilicon spacer 112 but before the formation of the silicon nitride spacer 114. This alternate process ensures the electrical connection between the intrinsic base 150 and the polysilicon spacer 112.

Following the intrinsic base formation, a low temperature / high pressure wet oxidation (HYPOX) process is performed. This process oxidizes heavily doped silicon much faster than lightly doped silicon. The process used here has a temperature of approximately 600-800 degrees celcius and a pressure of approximately 1-2MPa (10-20 atmospheres). Figure 8 illustrates that the exposed polysilicon of the sidewall spacers and the exposed single crystal silicon are oxidized. The oxidized sidewall spacers 116 oxidize faster than the oxidized single crystal silicon layer 118 because the polysilicon is doped heavier than the single crystal silicon. Therefore, the vertical oxide thickness of layer 116 is approximately 100-200 nm while the thickness of layer 118 is approximately 10-20 nm after the HYPOX process. After the HYPOX process, a short RIE etch which etches silicon dioxide is performed. This RIE step removes layer 118 but leaves most of layer 116 because layer 116 is thicker than layer 118. Once layer 118 is removed, a blanket etch of silicon is done. The RIE etch gases are HCL, with Cl₂ and O₂ and Argon. The RIE is done at low power, approximately 500 watts and at approximately 1.33 Pa (10 mtorr) of pressure. This etch is very selective to remove silicon but not affect silicon dioxide. Therefore, the single crystal silicon under layer 118 is removed but the silicon dioxide layers 116 and 104 are unaffected.

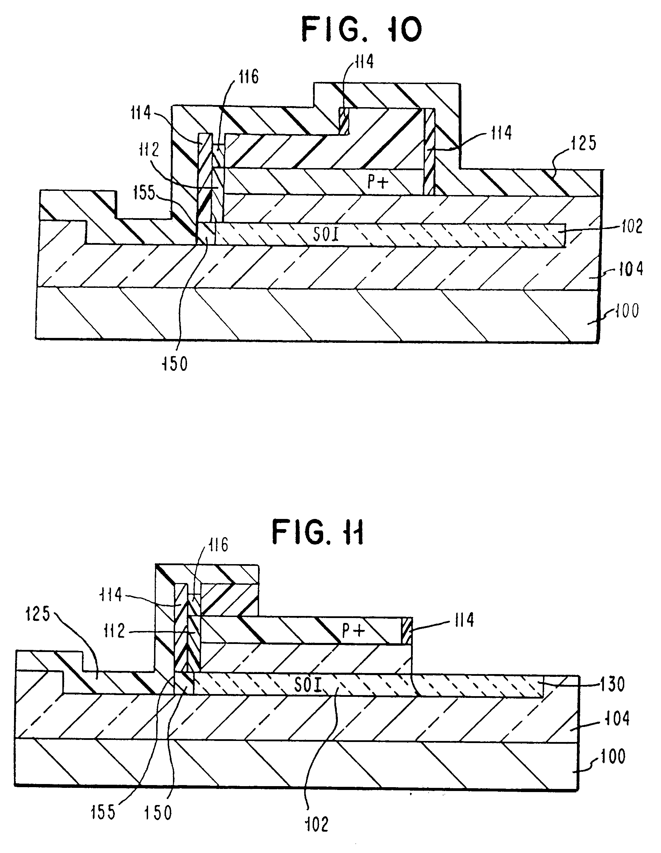

Figure 9 illustrates the device after the removal of the single crystal silicon in the emitter area. The p-type base which existed under the sidewall spacer layers still remains. Addtionally, the oxidized polysilicon layer 116 are etched back but still insulate layers 112. Layer 112 only contacts the extrinsic base 106 and the intrinsic base 150 because it is insulated by layers 116, 114, and 104C. Once the emitter area single crystal silicon has been etched, a second layer of polysilicon is deposited. Figure 10 illustrates a cross section of the present invention after the depostion of the second layer of polysilicon. The second polysilicon layer 125 is a heavily doped N type polysilicon layer and forms the emitter of the bipolar device. The deposition of polysilicon is carried out in a CVD tool in a conventional manner. The polysilicon is doped n-type in situ during the deposition. The n-type polysilicon has a concentration of approximately 10²¹/cm³. The n-type polysilicon layer 125 contacts the intrinsic base at the interface 155. There is a short thermal anneal which outdiffuses some N type dopant into the P type intrinsic base region. The outdiffusion of the N type dopant forms an emitter PN junction very close to the interface 155. The base width of the bipolar device is then defined by the width of the intrinsic base minus the outdiffusion of the N type dopant. The resulting basewidth is very narrow, on the order of 0.1 microns, which improves the performance of the device. Additionally, bipolar devices with polysilicon emitters typically have higher current gain than single crystal emitter devices. The remaining polysilicon contacts only silicon nitride or silicon dioxide and so any N type dopant outdiffusion into these areas has no effect. The thermal anneal is done at approximately 1000 degrees celcius for 5 seconds.

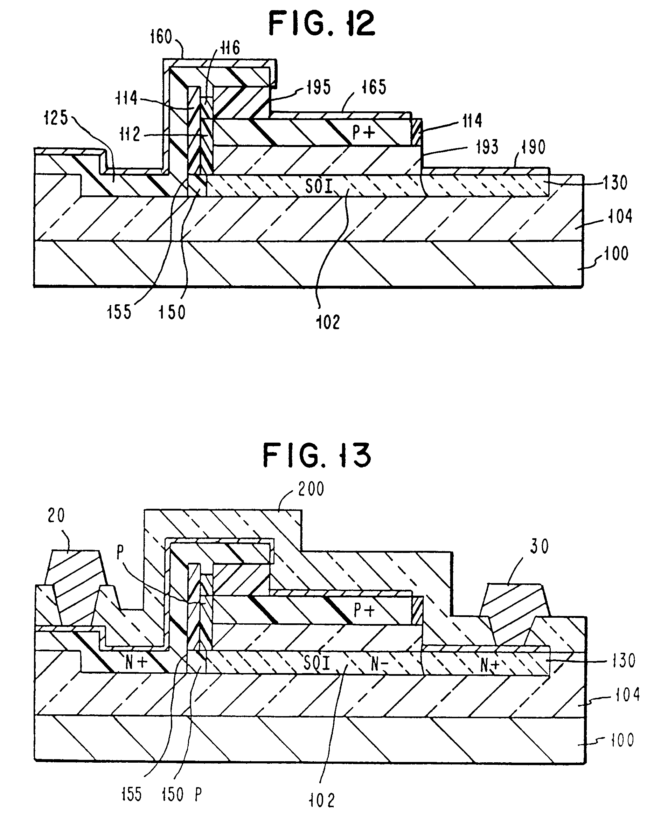

Figure 11 illustrates a cross section of the structure after the N type polysilicon 125 has been etched off and the base and collector contacts have been opened. Once the blanket N type polysilicon 125 has been deposited, the polysilicon and other dielectrics which cover the base and collector contacts must be removed. This is done in two steps. First the N type polysilicon 125 is etched following a conventional photoresist deposition and development step. The developed photoresist defines areas outside the emitter contact area which are to be etched. The first etch is isotropic and only etches silicon. The RIE process gas used in this step is SF₆ at approximately 200 watts and at high pressure (approximately 40 Pa (300 mtorr)). As a result, the polysilicon layer 125 is completely removed without etching the underlying dielectrics and the portions of polysilicon layer 125 protected by the photoresist remain. The second part of the two part etch process is to do a blanket etch which etches dielectrics but which does not etch silicon (selective to silicon). The dielectrics which are not covered by the N type polysilicon layer 125 at this point either cover the base contact, the collector contact, or cover a spacer layer between the base and collector. Therefore, etching these dielectrics opens up the base and collector contacts. The RIE etch gases are CHF₃ and O₂ done at high power, approximately 1400 watts and 2 Pa (15 mtorr) pressure. It is important that the N type polysilicon layer 125 overlaps the base contact and protects the base contact from this etch. This overlap is important because if the underlying dielectrics are etched away, the would be exposed to a direct connection to the emitter contact and the bipolar device would be shorted out. After the dielectric etch, the remaining photoresist covering the emitter polysilicon is removed in an oxygen plasma.

After the base and collector contacts are opened, a blanket N type implant is performed. This implant is to convert the silicon in the collector region to N+ doped silicon, and as a result, form a good collector contact. The implant is necessary because putting a metal contact on lightly doped N type silicon, which is exposed at this point in the process, does not form a good ohmic contact. Figure 11 illustrates that 3 types of silicon surfaces which are exposed to the implant; the N type emitter contact, the extrinsic base, and the collector contact. An N type implant into the collector is desired and the same implant into an N type emitter has no effect. The only concern then is the N type implant into the extrinsic base layer 106. The extrinsic base layer is very heavily doped with a P type dopant such that it is super-saturated having a concetration of approximately 10²¹/cm³. The blanket H type implant is of a dose such that the concetration of the resulting N+ region 130 in the collector has a concentration of approximately 10²⁰/cm³. Therefore, even though the N type implant does get into the P type extrinsic base, the implant has no effect on the extrinsic base because the heavy P type doping negates any effect from the N type implant. The N-type implant uses a phosphorous dopant with a dose of 10¹⁵/cm² and an energy of 20-40 keV.

After the collector diffusion 130 has been formed, the contacts are subjected to a silicide process. The silicide process improves the sheet resistance of the extrinsic base when used as a wiring level and improves the contact resistance between the wiring metallurgy and the emitter, base, and collector contacts. The silicide process begins with a blanket deposition of the silicide metal. Titanium is the metal deposited here but other metals are suitable such as tungsten or platinum. The titanium is deposited to a thickness of approximately 30 to 50 nm. The structure is then subjected to a low temperature anneal which transforms the titanium metal into a titanium silicide (TiSi₂) whereever the titanium metal comes into contact with silicon. The resulting titanium silicide layer is approximately 50 to 100 nm thick with a sheet resistance of approximately 5 to 10 ohm / square. Figure 12 illustrates that there is a silicide 160 over the polysilicon emitter contact, there is a silicide 165 on the exposed extrinsic base layer, and there is a silicide 190 over the collector contact. Where the silicide does not form is just as important as where the silicide does form. Specifically, there is no formation of silicide on the silicon nitride 195 which separates the emitter polysilicon contact from the extrinsic base. Similarly, there is no silicide formed on the silicon dioxide 193 or silicon nitride 114 layers which separate the extrinsic base from the collector contact. Therefore, because of the dielectric layers, the blanket silicide formation does not short out the bipolar device. Once the silicide contacts have been formed, a conventional passivation layer and wiring metallurgy can be deposited. Figure 13 illustrates that a 1,000 nm quartz layer 200 is blanket deposited onto the structure of figure 12. Emitter, collector, and base contact holes are defined via a conventional photoresist and development process. The contact holes are etched in a conventional RIE process. The RIE is selective to silicide and so will only etch the quartz layer (or other insulator layer) but will not etch the titanium silicide layer. The RIE gas is a combination of CHF₃ and O₂ and the etch is done at high power, approximately 1400 watts, at approximately 2 Pa (15 mtorr) of pressure. Once the contact holes are formed, a wiring metal such as an aluminum-copper alloy is deposited. Again, another photoresist process forms the emitter 20, base (not shown), and collector 30 wiring contacts. The base contact is not made directly between the emitter and collector contacts because the lateral distance between the emitter and collector can be reduced when the photolithography dimensions for a contact are not placed between the emitter and collector contacts. The emitter to collector distance can be reduced to the minimum width necessary to perform the silicide process over the extrinsic base. That minimum width in this process is approximately 0.5 microns. Figure 13 illustrates the final bipolar device structure of the present invention.

The key to the operation of the bipolar transistor illustrated in figure 13 is that the base width of the transistor is small and completely surrounded by dielectric so that there are very small parasitic capacitances to slow the operation of the device. As explained above, the base width is the difference between the lateral outdiffusion of the P type implanted region in the single crystal silicon and the N type outdiffusion from the emitter polysilicon. This difference is approximately 100 nm. The intrinsic base is connected to the extrinsic base by the polysilicon sidewall spacer. That polysilicon sidewall spacer can be doped P type when deposited or the connection made simply by the outdiffusion from the P+ doped extrinsic base into the sidewall spacer. Further, the silicon dioxide layer 104 which surrounds the base and collector ensures that parasitic capacitances to isolation do not exist.

The process of fabricating the device is especially useful because it does not require high temperature and long duration anneals. These type of processes make fabrication of FET devices on the same substrate very difficult. In the device illustrated in figure 13, the anneals used to outdiffuse dopant from the base polysilicon, or emitter polysilicon, or perform the silicide processes have a minimal thermal effect. The total anneals for these steps are 800 degrees for 5 minutes, 1000 degrees for 5 seconds, and 900 degrees for 1 second. These temperatures easily allow for high performance FET devices to be fabricated on the same substrate. The process is also very useful because the formation of the base width does not require a minimum photolithographic image size to make a device with a minimum base width, and hence, maximum performance. Finally, the device will have high device gain because the polysilicon emitter has less recombination current than the single crystal silicon emitter which results in higher gain for the bipolar device.

## Claims

1. A bipolar transistor comprising:
a dielectric layer (104) disposed between a first polysilicon layer (106) and a single crystal silicon layer (130), said single crystal silicon layer disposed below said dielectric layer and having a horizantal and vertical surface, said first polysilicon layer doped with a first type of dopant;
said single crystal silicon layer having a first region doped with said first type of dopant and a second region doped with a second type of dopant;
a second polysilicon layer (112) doped with said first type of dopant, said second polysilicon layer electrically connects said first polysilicon layer to said first region of said single crystal silicon; and
a third polysilicon layer (125) doped with said second type of dopant, said third polysilicon layer attaches to said first region of said single crystal silicon layer through said vertical surface of said single crystal silicon layer.

2. A bipolar transistor, as in claim 1, wherein:
said second polysilicon layer (112) connects said first polysilicon layer (106) to said first region of said single crystal silicon through said horizontal surface of said single crystal silicon.

3. A bipolar transistor, as in claim 2, further comprising:
a spacer layer (114) disposed between said third polysilicon layer (125) and said second polysilicon layer for electrically insulating said second polysilicon layer (112) from said third polysilicon layer.

4. A bipolar transistor, as in claim 2, further comprising:
a silicide layer (101) formed on said first and third polysilicon layers.

5. A bipolar transistor, as in claim 4, wherein:
said silicide layer is formed from a metal element selected from the group of titanium, tungsten, platinum.

6. A method of making a bipolar transistor comprising:
forming a dielectric layer (104) between a first polysilicon layer (106) and a single crystal silicon layer (130), said single crystal silicon layer disposed below said dielectric layer and having a horizantal and vertical surface, said first polysilicon layer doped with a first type of dopant;
doping a first region of said single crystal silicon layer with said first type of dopant and doping a second region of said single crystal silicon layer with a second type of dopant;
electrically connecting said first polysilicon layer to said first region of said single crystal silicon with a second polysilicon layer, said second polysilicon layer doped with said first type of dopant; and
attaching a third polysilicon layer doped with said second type of dopant to said first region of said single crystal silicon layer through said vertical surface of said single crystal silicon layer.

7. A method of making a bipolar transistor, as in claim 6, wherein:
said second polysilicon layer connects said first polysilicon layer to said single crystal silicon through said horizantal surface of said single crystal silicon.

8. A method of making a bipolar transistor, as in claim 7, further comprising:
forming a spacer layer between said third polysilicon layer and said second polysilicon layer for electrically insulating said second polysilicon layer from said third polysilicon layer.

9. A method of making a bipolar transistor, as in claim 7 or 8, further comprising:
forming a silicide layer on said first and third polysilicon layers.

10. A method of making a bipolar transistor, as claimed in any one of the preceding claims 6 to 9, wherein:
said silicide layer is formed from a metal element selected from the group of titanium, tungsten, platinum.
